# DEMANDE DE BREVET EUROPEEN

(11) **EP 4 369 387 A2**
(43) Date de publication de la demande: **15.05.2024**
(21) Numéro de dépôt: 23208356.8
(22) Date de dépôt: 07.11.2023
(51) Int. Cl.: H01L 21/822, H01L 29/06, H01L 21/8234, H01L 21/8238, H01L 27/06, H01L 29/66, H01L 29/423, H01L 29/775, H01L 29/786, H01L 27/12

(54) **EMPILEMENT DE COUCHES MONOCRISTALLINES POUR LA RÉALISATION DE DISPOSITIFS MICROÉLECTRONIQUES À ARCHITECTURE 3D**

(30) Priorité: 08.11.2022 FR 2211627
(71) Demandeur: Commissariat à l'énergie atomique et aux énergies alternatives, 75015 Paris (FR)
(72) Inventeur: BARRAUD, Sylvain, 38054 GRENOBLE CEDEX 09 (FR); REBOH, Shay, 38054 GRENOBLE CEDEX 09 (FR)
(74) Mandataire: Brevalex

(57) **Abrégé**

Empilement (100) de couches de matériaux monocristallins adapté à la réalisation de dispositifs microélectroniques à architecture 3D comprenant des transistors, incluant plusieurs premières couches (104) de matériau monocristallin, plusieurs deuxièmes couches (106) de matériau monocristallin différent de celui des premières couches, et au moins une troisième couche (108) de matériau monocristallin différent de ceux des premières et deuxièmes couches, dans lequel :
- un premier des matériaux monocristallins des premières, deuxièmes et troisième couches correspond à du silicium intrinsèque ;
- un deuxième des matériaux monocristallins des premières, deuxièmes et troisième couches correspond à du SiGe intrinsèque ;
- un troisième des matériaux monocristallins des premières, deuxièmes et troisième couches correspond à du silicium dopé p ou du SiGe dopé p.

## Description

### DOMAINE TECHNIQUE

L'invention concerne le domaine des dispositifs microélectroniques à architecture 3D comprenant des transistors, notamment réalisés à partir d'empilement multicouches de matériaux monocristallins. L'invention s'applique en particulier à la réalisation de transistors en technologie MOS avancée GAA (« Gate-All-Around » en anglais, ou à grille enrobante) de type NanoSheet (ou à nano-feuilles), ForkSheet (ou à feuille de fourche) ou CFET (« Complementary Field-Effect Transistors », ou transistors à effet de champ complémentaires), ou bien à la réalisation de dispositifs mémoires à architecture 3D incluant des transistors d'accès en technologie MOS avancée GAA et par exemple de type 1T1R (chaque point mémoire étant formé par un élément résistif couplé à un transistor d'accès) ou 1T1C (chaque point mémoire étant formé par un élément capacitif couplé à un transistor d'accès).

### ÉTAT DE LA TECHNIQUE ANTERIEURE

Les dernières technologies CMOS utilisent (et utiliseront) une disposition alternée de couches de deux matériaux semi-conducteurs qui peuvent être éliminées sélectivement l'une par rapport à l'autre. Ceci fournit les conditions pour obtenir des couches dites "suspendues" et créer un transistor GAA. Les couches utilisées sont en général formées de Si, Ge, SiGe ou GeSn, la technologie la plus répandue étant cependant basée sur une alternance de couches de Si et de SiGe.

La technologie des transistors GAA basée sur une alternance de couches de Si et de SiGe fait appel à du SiGe avec une concentration de Ge comprise entre 25 et 35 %, et des épaisseurs typiquement inférieures à 15 nm pour chaque couche de Si et de SiGe. En termes de conception, un aspect qui limite le nombre total de couches alternées réalisables est la stabilité mécanique de la structure. Dans le cas d'une croissance Si/SiGe sur un substrat Si, les couches de SiGe sont sous contrainte en compression. Les couches peuvent conserver cette contrainte jusqu'à une certaine épaisseur dite épaisseur critique (voir par exemple le document de J. M. Hartmann et al., « Critical thickness for plastic relaxation of SiG on Si(001) revisited », Journal of applied Physics, vol. 110, 083529 (2011)). Pour une épaisseur plus importante, la couche de SiGe relâchera une partie de cette contrainte en émettant des dislocations, ce qui est préjudiciable aux performances/fonctionnalités du dispositif. Il en va de même pour l'empilement multicouche. A titre indicatif, la concentration moyenne en Ge dans l'empilement est prise pour définir l'épaisseur critique de l'empilement. Il est alors clair qu'utiliser une concentration en Ge plus élevée pour les couches de l'empilement limite l'épaisseur totale de SiGe dans l'empilement. Il faut alors trouver un compromis entre le nombre de couches, la sélectivité de gravure et la stabilité mécanique.

Pour certaines applications, une troisième couche de troisième sélectivité de gravure peut être ajoutée, par exemple pour isoler le transistor du substrat ou pour isoler deux niveaux de canal ou deux transistors superposés qui peuvent être par exemple des transistors complémentaires (nMOS et pMOS). Lorsque cette troisième couche est à base d'alliages SiGe, elle doit avoir une concentration en Ge significativement supérieure à la concentration en Ge dans l'autre SiGe, c'est-à-dire d'au moins 50 % pour assurer une sélectivité de gravure suffisante. L'article de J. M. Hartmann et al., « Critical thickness for plastic relaxation of SiG on Si(001) revisited », Journal of applied Physics, vol. 110, 083529 (2011), montre que l'épaisseur critique n'est pas une caractéristique linéaire par rapport à la concentration de Ge, mais qu'elle diminue fortement avec l'augmentation de la concentration de Ge. Cela amène donc un point critique en termes de conception, concernant la stabilité mécanique de la structure, qui peut être à terme rédhibitoire.

Cette limitation de l'épaisseur totale de l'empilement se traduit donc par une limitation du nombre total de couches de l'empilement. Par exemple, un empilement de type tri-couches comprenant une alternance de couches de silicium, de Si_{0,75}Ge_{0,25} et de Si_{0,5}Ge_{0,5}, dont les épaisseurs sont comprises entre 12 nm et 13 nm, a une épaisseur critique comprise entre 100 nm et 150 nm. Dans ce cas, le nombre de couches superposées servant à former les canaux des transistors est au maximum de 3. Une forte concentration de germanium au sein d'un tel empilement limite donc la capacité mémoire atteignable par unité de surface lorsque cet empilement est utilisé pour réaliser un dispositif mémoire à architecture 3D, ou limite la densité de courant atteignable lorsque cet empilement est utilisé pour réaliser des transistors à architecture 3D.

En outre, la sélectivité de gravure entre les couches de Si_{0,8}Ge_{0,2}, ou Si_{0,75}Ge_{0,25}, et les couches de Si_{0,5}Ge_{0,5} n'est pas suffisante pour éviter de consommer l'une de ces couches lors d'une gravure de l'autre de ces couches.

### EXPOSÉ DE L'INVENTION

Un but de la présente invention est de proposer un empilement de couches adapté à la réalisation de dispositifs microélectroniques à architecture 3D comprenant des transistors, résolvant au moins en partie le problème de sélectivité de gravure expliqué ci-dessus et pouvant avoir une épaisseur importante (par exemple supérieure à 100 nm ou à 150 nm) tout en minimisant ou supprimant la génération de dislocations par relaxation plastique au sein de l'empilement, afin d'améliorer la densité de mémoire (par unité de surface) ou le nombre de couches actives (canaux des transistors) atteignable par les dispositifs réalisés à partir d'un tel empilement.

Pour cela, l'invention propose un empilement de couches adapté à la réalisation de dispositifs microélectroniques à architecture 3D comprenant des transistors, incluant plusieurs premières couches de silicium non intentionnellement dopé, plusieurs deuxièmes couches de SiGe non intentionnellement dopé, et au moins une troisième couche de silicium dopé de type P ou de SiGe dopé de type P, et tel que les premières, deuxièmes et troisième couches soient empilées les unes au-dessus des autres.

Par rapport aux empilements tri-couches utilisés dans l'art antérieur, il est proposé de remplacer la ou les couches de SiGe la plus concentrée en Ge par au moins une couche de silicium dopé de type P ou de SiGe possédant un dopage de type P et par exemple faiblement concentré en Ge. Ainsi, cet empilement ne présente pas les inconvénients liés à la présence d'une couche de SiGe à forte concentration de Ge, ce qui permet d'améliorer au final la densité de mémoire (par unité de surface) ou le nombre de couches actives (canaux des transistors) atteignable par les dispositifs réalisés à partir d'un tel empilement, tout en minimisant ou supprimant la génération de dislocations par relaxation plastique par dépassement de l'épaisseur critique au sein de l'empilement.

De plus, la ou les couches de silicium dopé de type P ou de SiGe dopé de type P peuvent avoir une épaisseur supérieure à la ou les couches de SiGe à forte concentration de Ge utilisées dans l'art antérieur car leur épaisseur critique avant l'apparition de dislocations est plus importante. Cela permet par exemple, lorsque cette ou ces couches de silicium dopé de type P ou de SiGe dopé de type P sont destinées à être gravées puis remplacées par un ou plusieurs matériaux diélectriques d'isolation, de former une meilleure isolation entre des structures empilées formées dans l'empilement grâce à la réalisation d'une structure isolante plus épaisse et/ou comprenant un matériau isolant de faible permittivité.

Enfin, la sélectivité de gravure obtenue entre le silicium dopé de type P, ou le SiGe dopé de type P, et le silicium non intentionnellement dopé et le SiGe non intentionnellement dopé est plus importante que celle obtenue dans les empilements tri-couches de l'art antérieur, ce qui évite une consommation excessive des matériaux de l'empilement lors de la mise en oeuvre des gravures sélectives de ces matériaux.

Avantageusement, ladite au moins une troisième couche est en un matériau semi-conducteur apte à être gravé sélectivement par rapport aux matériaux semi-conducteurs respectifs des premières couches et des deuxième semi-conductrices.

Avantageusement, dans ledit empilement, ladite au moins une troisième couche comporte une face dite « inférieure », disposée sur et en contact d'une couche semi-conductrice donnée parmi lesdites premières ou deuxièmes couches ou est disposée sur et en contact d'une couche semi-conductrice d'un substrat. Ladite au moins une troisième couche peut être également dotée d'une face dite « supérieure » opposée à sa face inférieure et disposée sous et en contact avec une autre couche semi-conductrice parmi lesdites premières ou deuxièmes couches. Ladite autre couche semi-conductrice est typiquement distincte de la dite couche semi-conductrice donnée, de sorte que si la troisième couche semi-conductrice est en contact par une face, inférieure ou supérieure, avec une première couche, cette même troisième couche semi-conductrice est typiquement en contact par sa face opposée, supérieure ou inférieure, avec une deuxième couche.

Selon une possibilité de mise en oeuvre, l'empilement peut être entièrement constitué de trois matériaux semiconducteur différents.

Selon une possibilité de mise en oeuvre, l'empilement peut entièrement constitué desdites premières couches de silicium non intentionnellement dopé, desdites deuxièmes couches de SiGe non intentionnellement dopé, et de ladite au moins une troisième couche de silicium dopé de type P ou du SiGe dopé de type P.

Dans l'empilement proposé, les couches peuvent être empilées telles que chaque première couche soit disposée entre, et être en contact avec, deux deuxièmes couches ou deux troisièmes couches, et/ou telle que chaque deuxième couche soit disposée entre, et être en contact avec, deux premières couches ou deux troisièmes couches. Cette caractéristique peut ne pas s'appliquer à certaines des premières ou deuxièmes couches, comme par exemple celles se trouvant au sommet de l'empilement et/ou celles se trouvant à la base de l'empilement.

De manière générale, les semi-conducteurs des premières, deuxièmes et troisièmes couches peuvent être monocristallins, ce qui est avantageux en particulier pour le semi-conducteur destiné à former des canaux de transistors. En variante, il est possible que les semi-conducteurs des premières, deuxièmes et troisièmes couches soient polycristallins.

Le dopage de type P du silicium ou du SiGe peut être obtenu par des atomes de Bore par exemple.

Le silicium ou le SiGe de la troisième couche peut avoir une concentration en dopants de type P supérieure ou égale à 5.10¹⁹ at/cm³, et avantageusement supérieure ou égale à 1.10²⁰ at/cm³.

Le SiGe non intentionnellement dopé peut avoir une concentration en germanium supérieure ou égale à 10 %, ou supérieure ou égale à 20 %, et inférieure à 50 %.

Le nombre de premières ou deuxièmes couches de l'empilement peut être compris entre 4 et 300.

Dans un premier mode de réalisation, chacune des premières et deuxièmes couches peut être disposée entre deux troisièmes couches et être en contact avec ces deux troisièmes couches. Un empilement selon ce premier mode de réalisation peut avantageusement être utilisé pour la réalisation de dispositifs mémoires à architecture 3D incluant des transistors d'accès en technologie MOS avancées.

Dans une variante de ce premier mode de réalisation, l'empilement peut comporter en outre plusieurs autres troisièmes couches de silicium dopé de type P ou du SiGe dopé de type P, et chacune des premières et troisièmes couches peut être disposée entre deux des deuxièmes couches et être en contact avec ces deux deuxièmes couches.

Dans un deuxième mode de réalisation, l'empilement peut comprendre au moins :
- un premier sous-empilement formé d'une alternance de premières et deuxièmes couches et tel que chaque première couche du premier sous-empilement soit disposé entre deux deuxièmes couches du premier sous-empilement ou que chaque deuxième couche du premier sous-empilement soit disposée entre deux premières couches du premier sous-empilement ;
- un deuxième sous-empilement formé d'une alternance de premières et deuxièmes couches et tel que chaque première couche du deuxième sous-empilement soit disposée entre deux deuxièmes couches du deuxième sous-empilement ou que chaque deuxième couche du deuxième sous-empilement soit disposée entre deux premières couches du deuxième sous-empilement ;
et la troisième couche peut être disposée entre les premier et deuxième sous-empilements. Un empilement selon ce deuxième mode de réalisation peut avantageusement être utilisé pour la réalisation des transistors CFET, c'est-à-dire des transistors de type n et p superposés l'un au-dessus de l'autre et dont les canaux sont formés par une superposition de nanofils ou nano-feuilles.

Dans ce deuxième mode de réalisation, l'empilement peut comporter en outre plusieurs autres troisièmes couches de silicium dopé de type P ou du SiGe dopé de type P entre lesquelles les premier et deuxième sous-empilements sont disposés.

Dans un troisième mode de réalisation, les premières et deuxièmes couches peuvent être disposées les unes au-dessus des autres de manière alternée, et la troisième couche peut être disposée sous l'ensemble formé par les premières et deuxièmes couches. Un empilement selon ce troisième mode de réalisation peut avantageusement être utilisé pour la réalisation de transistors CMOS GAA.

L'invention concerne également un premier procédé de réalisation de dispositifs microélectroniques à architecture 3D comprenant des transistors, comportant la mise en oeuvre des étapes suivantes :
a) réalisation d'un empilement selon le premier mode de réalisation sur un substrat et dans lequel chacune des premières et deuxièmes couches est disposée entre deux troisièmes couches et est en contact avec ces deux troisièmes couches ;
b) gravure de tranchées et/ou de cavités à travers au moins une partie de l'épaisseur de l'empilement, telle que des portions restantes des premières, deuxièmes et troisièmes couches forment des nanofils ou des nano-feuilles ;
c) gravure sélective d'une partie des portions restantes des premières couches telle que des parties restantes des premières couches soient configurées pour former des canaux des transistors ;
d) dépôt d'au moins un premier matériau diélectrique dans des premiers espaces formés par la gravure sélective d'une partie des portions restantes des premières couches, à côté des canaux des transistors ;
e) gravure sélective d'au moins une partie des portions restantes des deuxièmes couches ;
f) dépôt d'au moins un deuxième matériau diélectrique dans des seconds espaces formés par la gravure sélective d'au moins une partie des portions restantes des deuxièmes couches, entre les portions restantes des troisièmes couches ;
g) gravure sélective des portions restantes des troisièmes couches ;
h) dépôt d'au moins un diélectrique de grille et d'au moins un matériau conducteur de grille dans des troisièmes espaces formés par la gravure sélective des portions restantes des troisièmes couches, formant une grille au moins au-dessus et en dessous de chacun des canaux des transistors.

En variante, l'invention propose également un procédé de réalisation de dispositifs microélectroniques à architecture 3D comprenant des transistors, comportant la mise en oeuvre des étapes suivantes :
a) réalisation d'un empilement selon le premier mode de réalisation sur un substrat et dans lequel chacune des premières et deuxièmes couches est disposée entre deux troisièmes couches et est en contact avec ces deux troisièmes couches ;
b) gravure de tranchées et/ou de cavités à travers au moins une partie de l'épaisseur de l'empilement, telle que des portions restantes des premières, deuxièmes et troisièmes couches forment des nanofils ou des nano-feuilles ;
c) gravure sélective d'une partie des portions restantes des deuxièmes couches telle que des parties restantes des deuxièmes couches soient configurées pour former des canaux des transistors ;
d) dépôt d'au moins un premier matériau diélectrique dans des premiers espaces formés par la gravure sélective d'une partie des portions restantes des deuxièmes couches, à côté des canaux des transistors ;
e) gravure sélective d'au moins une partie des portions restantes des premières couches ;
f) dépôt d'au moins un deuxième matériau diélectrique dans des seconds espaces formés par la gravure sélective d'au moins une partie des portions restantes des premières couches, entre les portions restantes des troisièmes couches ;
g) gravure sélective des portions restantes des troisièmes couches ;
h) dépôt d'au moins un diélectrique de grille et d'au moins un matériau conducteur de grille dans des troisièmes espaces formés par la gravure sélective des portions restantes des troisièmes couches, formant une grille au moins au-dessus et en dessous de chacun des canaux des transistors.

Les deux procédés ci-dessus peuvent avantageusement être mis en oeuvre pour réaliser des dispositifs mémoires à architecture 3D incluant des transistors d'accès en technologie MOS avancées.

Selon une autre variante de ce premier mode de réalisation, l'invention propose un procédé de réalisation de dispositifs microélectroniques à architecture 3D comprenant des transistors, comportant la mise en oeuvre des étapes suivantes :
a) réalisation d'un empilement selon le premier mode de réalisation sur un substrat, l'empilement comportant en outre plusieurs autres troisièmes couches de silicium dopé de type P ou du SiGe dopé de type P, et dans lequel chacune des premières et troisièmes couches est disposée entre deux deuxièmes couches et est en contact avec ces deux deuxièmes couches ;
b) gravure de tranchées et/ou de cavités à travers au moins une partie de l'épaisseur de l'empilement, telle que des portions restantes des premières, deuxièmes et troisièmes couches forment des nanofils ou des nano-feuilles ;
c) gravure sélective d'une partie des portions restantes des premières couches telle que des parties restantes des premières couches soient configurées pour former des canaux des transistors ;
d) dépôt d'au moins un premier matériau diélectrique dans des premiers espaces formés par la gravure sélective d'une partie des portions restantes des premières couches, à côté des canaux des transistors ;
e) gravure sélective d'au moins une partie des portions restantes des troisièmes couches ;
f) dépôt d'au moins un deuxième matériau diélectrique dans des seconds espaces formés par la gravure sélective d'au moins une partie des portions restantes des troisièmes couches, entre les portions restantes des deuxièmes couches ;
g) gravure sélective des portions restantes des deuxièmes couches ;
h) dépôt d'au moins un diélectrique de grille et d'au moins un matériau conducteur de grille dans des troisièmes espaces formés par la gravure sélective des portions restantes des deuxièmes couches, formant une grille au moins au-dessus et en dessous de chacun des canaux des transistors.

En variante, les étapes e) et f) peuvent être mises en oeuvre entre les étapes b) et c).

L'invention concerne également un deuxième procédé de réalisation de dispositifs microélectroniques à architecture 3D comprenant des transistors, comportant la mise en oeuvre des étapes suivantes :
a) réalisation d'un empilement selon le deuxième mode de réalisation sur un substrat ;
b) gravure de tranchées et/ou de cavités à travers au moins une partie de l'épaisseur de l'empilement, telle que des portions restantes des premières et deuxièmes couches des premier et deuxième sous-empilements et des portions restante de la troisième couche ou des troisièmes couches forment des nanofils ou des nano-feuilles ;
c) gravure sélective d'au moins une partie des portions restantes de la troisième couche ou des troisièmes couches ;
d) dépôt d'au moins un premier matériau diélectrique dans des premiers espaces formés par la gravure sélective d'au moins une partie des portions restantes de la troisième couche ;
e) gravure sélective d'au moins une partie des portions restantes des deuxièmes couches du premier sous-empilement lorsque, dans le premier sous-empilement, chaque première couche est disposée entre deux deuxièmes couches, ou gravure sélective d'au moins une partie des portions restantes des premières couches du premier sous-empilement lorsque, dans le premier sous-empilement, chaque deuxième couche est disposée entre deux premières couches ;
f) dépôt d'au moins un diélectrique de grille et d'au moins un matériau conducteur de grille dans des deuxièmes espaces formés par la gravure sélective de l'étape e), formant une grille au moins au-dessus et en dessous de chacune des portions restantes des premières ou deuxièmes couches du premier sous-empilement.

Un tel procédé peut avantageusement être mis en oeuvre pour réaliser des transistors CFET.

Ce deuxième procédé peut être tel que :
- lorsque chaque première couche est disposée entre deux deuxièmes couches dans les premier et deuxième sous-empilements, l'étape e) inclut également une gravure sélective d'au moins une partie des portions restantes des deuxièmes couches du deuxième sous-empilement, et l'étape f) inclut également un dépôt du diélectrique de grille et du matériau conducteur de grille dans des troisièmes espaces formés par la gravure sélective d'au moins une partie des portions restantes des deuxièmes couches du deuxième sous-empilement, formant une grille au moins au-dessus et en dessous de chacune des portions restantes des premières couches du deuxième sous-empilement, ou
- lorsque chaque deuxième couche est disposée entre deux premières couches dans les premier et deuxième sous-empilements, l'étape e) inclut également une gravure sélective d'au moins une partie des portions restantes des premières couches du deuxième sous-empilement, et l'étape f) inclut également un dépôt du diélectrique de grille et du matériau conducteur de grille dans des troisièmes espaces formés par la gravure sélective d'au moins une partie des portions restantes des premières couches du deuxième sous-empilement, formant une grille au moins au-dessus et en dessous de chacune des portions restantes des deuxièmes couches du deuxième sous-empilement, ou
- lorsque chaque première couche est disposée entre deux deuxièmes couches dans le premier sous-empilement et que chaque deuxième couche est disposée entre deux premières couches dans le deuxième sous-empilement, le procédé comporte en outre, après l'étape f), une étape g) de gravure sélective d'au moins une partie des portions restantes des premières couches du deuxième sous-empilement, puis une étape h) de dépôt d'au moins un diélectrique de grille et d'au moins un matériau conducteur de grille dans des troisièmes espaces formés par la gravure d'au moins une partie des portions restantes des premières couches du deuxième sous-empilement, formant une grille au moins au-dessus et en dessous de chacune des portions restantes des deuxièmes couches du premier sous-empilement, ou
- lorsque chaque deuxième couche est disposée entre deux premières couches dans le premier sous-empilement et que chaque première couche est disposée entre deux deuxièmes couches dans le deuxième sous-empilement, le procédé comporte en outre, après l'étape f), une étape g) de gravure sélective d'au moins une partie des portions restantes des deuxièmes couches du deuxième sous-empilement, puis une étape h) de dépôt d'au moins un diélectrique de grille et d'au moins un matériau conducteur de grille dans des troisièmes espaces formés par la gravure sélective d'au moins une partie des portions restantes des deuxièmes couches du deuxième sous-empilement, formant une grille au moins au-dessus et en dessous de chacune des portions restantes des premières couches du premier sous-empilement.

L'invention concerne également un procédé de réalisation de dispositifs microélectroniques à architecture 3D comprenant des transistors, comportant la mise en oeuvre des étapes suivantes :
a) réalisation d'un empilement selon le troisième mode de réalisation sur un substrat ;
b) gravure de tranchées et/ou de cavités à travers au moins une partie de l'épaisseur de l'empilement, telle que des portions restantes des premières et deuxièmes couches des premier et deuxième sous-empilements et des portions restantes de la troisième couche forment des nanofils ou des nano-feuilles ;
c) gravure sélective d'au moins une partie des portions restantes de la troisième couche ;
d) dépôt d'au moins un premier matériau diélectrique dans des premiers espaces formés sous les portions restantes des premières et deuxièmes couches, assurant une isolation électrique entre les portions restantes des premières et deuxièmes couches et le substrat ;
e) gravure sélective d'au moins une partie des portions restantes des premières couches ou des deuxièmes couches ;
f) dépôt d'au moins un diélectrique de grille et d'au moins un matériau conducteur de grille dans des deuxièmes espaces formés par la gravure d'au moins une partie des portions restantes des premières couches ou des deuxièmes couches, formant une grille au moins au-dessus et en dessous de chacune des portions restantes des premières couches ou des deuxièmes couches.

Un tel procédé peut avantageusement être mis en oeuvre pour réaliser des transistors CMOS GAA.

Dans l'ensemble du document, le terme « sur » est utilisé sans distinction de l'orientation dans l'espace de l'élément auquel se rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Dans les procédés de réalisation décrits ci-dessus ainsi que dans les modes de réalisation particuliers décrits plus loin, les étapes décrites ne sont pas nécessairement mises en oeuvre directement les unes après les autres, car des étapes intermédiaires peuvent être mises en oeuvre entre deux étapes de ces procédés.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 représente un empilement de couches de matériaux monocristallins adapté à la réalisation de dispositifs microélectroniques à architecture 3D comprenant des transistors, objet de la présente invention, selon un premier mode de réalisation.
La figure 2 représente les étapes d'un procédé de réalisation de dispositifs microélectroniques à architecture 3D comprenant des transistors, objet de la présente invention, mis en oeuvre à partir d'un empilement selon le premier mode de réalisation.
La figure 3 représente les étapes d'une variante du procédé décrit en lien avec la figure 2.
La figure 4 représente un empilement de couches de matériaux monocristallins adapté à la réalisation de dispositifs microélectroniques à architecture 3D comprenant des transistors CFET, objet de la présente invention, selon un deuxième mode de réalisation.
Les figures 5 et 6 représentent les étapes d'un procédé de réalisation de dispositifs microélectroniques à architecture 3D comprenant des transistors CFET, objet de la présente invention, mis en oeuvre à partir d'un empilement selon le deuxième mode de réalisation.
La figure 7 représente un empilement de couches de matériaux monocristallins adapté à la réalisation de dispositifs microélectroniques à architecture 3D comprenant des transistors CFET, objet de la présente invention, selon une variante du deuxième mode de réalisation.
Les figures 8 et 9 représentent les étapes d'un procédé de réalisation de dispositifs microélectroniques à architecture 3D comprenant des transistors CFET, objet de la présente invention, mis en oeuvre à partir d'un empilement selon la variante du deuxième mode de réalisation.
La figure 10 représente un empilement de couches de matériaux monocristallins adapté à la réalisation de dispositifs microélectroniques à architecture 3D comprenant des transistors GAA, objet de la présente invention, selon un troisième mode de réalisation.
Les figures 11 et 12 représentent les étapes d'un procédé de réalisation de dispositifs microélectroniques à architecture 3D comprenant des transistors GAA, objet de la présente invention, mis en oeuvre à partir d'un empilement selon le troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSE DETAILLE DE MODES DE REALISATION PARTICULIERS

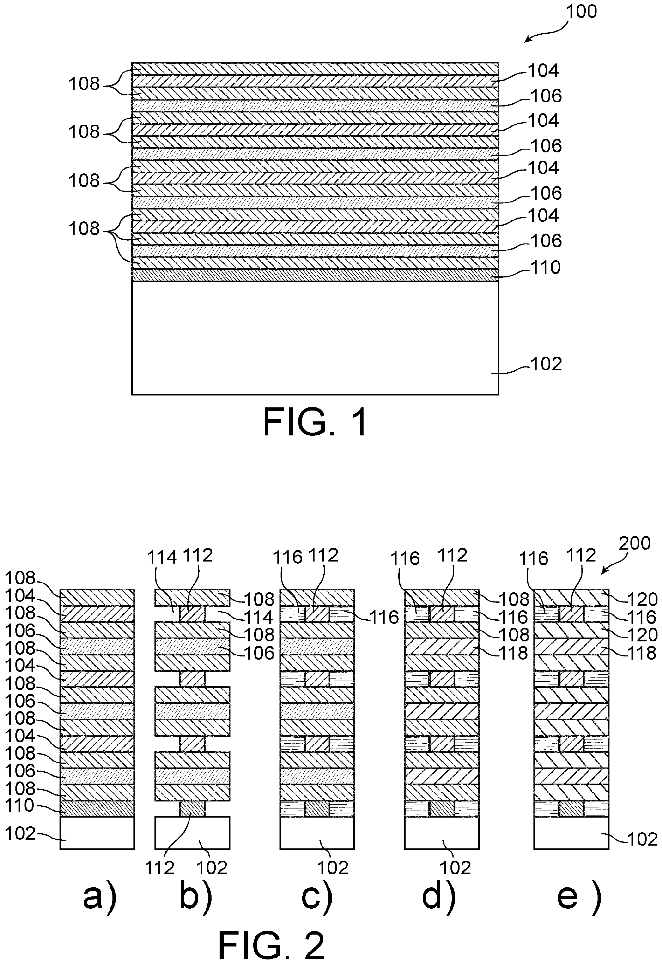

Un empilement 100 de couches de matériaux monocristallins adapté à la réalisation de dispositifs microélectroniques à architecture 3D comprenant des transistors, selon un premier mode de réalisation, est décrit ci-dessous en lien avec la figure 1.

L'empilement 100 est disposé sur un substrat 102 correspondant par exemple à un substrat bulk, ou massif, de semi-conducteur, par exemple de silicium. De manière avantageuse, le substrat 102 peut correspondre à un substrat de type semi-conducteur sur isolant, par exemple SOI (« Silicon On Insulator » en anglais, ou silicium sur isolant).

L'empilement 100 comporte plusieurs premières couches 104 de silicium non intentionnellement dopé, plusieurs deuxièmes couches 106 de SiGe non intentionnellement dopé, et au moins une troisième couche 108 (plusieurs troisièmes couches 108 dans l'exemple de la figure 1) de silicium dopé de type P ou de SiGe dopé de type P.

Dans le premier mode de réalisation, chacune des premières et deuxièmes couches 104, 106 est disposée entre deux troisièmes couches 108 et est en contact avec ces deux troisièmes couches 108. Sur l'exemple de la figure 1, l'empilement 100 comporte quatre premières couches 104, quatre deuxièmes couches 106 et neuf troisièmes couches 108.

L'empilement 100 représenté sur la figure 1 comporte également une couche 110 similaire à l'une des premières couches 104 et disposée entre le substrat 102 et l'empilement 100. Dans l'exemple de réalisation décrit, contrairement aux premières couches 104, la couche 110 n'est pas disposée entre deux troisièmes couches 108. En variante, il est possible d'avoir la couche 110 disposée entre deux troisièmes couches 108. Dans le cas d'un substrat 102 de type SOI, la couche 110 peut correspondre à la couche superficielle de silicium de ce substrat 102, une couche diélectrique enterrée, ou BOX (« Buried-Oxide » en anglais) étant dans ce cas présente sous la couche 110 (un tel BOX n'est pas visible sur la figure 1).

Dans une variante, il est possible que l'empilement 100 comporte, à son sommet, une couche de SiGe non intentionnellement dopé plus épaisse que les couches 106.

De manière avantageuse, le nombre total de premières couches 104 de l'empilement 100 est compris entre 4 et 300.

Dans l'exemple de réalisation particulier de la figure 1, une troisième couche 103 est dotée d'une face inférieure agencée sur et en contact d'une couche 110 superficielle de silicium de ce substrat 102 et d'une face supérieure opposée à la face supérieure qui est disposée sous et en contact d'une couche 106.

D'autres troisième couches 103 sont dotées d'une face inférieure qui disposée sur et en contact d'une première couche 104 et d'une face supérieure qui est disposée sur et en contact d'une deuxième couche 106 ou bien d'une face inférieure qui disposée sur et en contact d'une deuxième couche 106 et d'une face supérieure qui est disposée sur et en contact d'une première couche 104.

Dans l'exemple de réalisation représenté sur la figure 1, les troisièmes couches 108 comportent du silicium dopé de type P. En outre, le silicium des troisièmes couches a une concentration en dopants de type p, correspondant avantageusement à des atomes de bore, supérieure ou égale à 5.10¹⁹ at/cm³, voire supérieure ou égale à 10²⁰ at/cm³. De plus, dans l'exemple de réalisation décrit ici, le SiGe non intentionnellement dopé a une concentration en germanium supérieure ou égale à 10 %, ou supérieure ou égale à 20 %, et par exemple égale à 30 %. En outre, dans cet exemple de réalisation, le SiGe non intentionnellement dopé a également une concentration en germanium inférieure à 50 %.

L'épaisseur de chacune des couches 104, 106, 108 et 110 est par exemple comprise entre 5 nm et 30 nm.

Un procédé de réalisation de dispositifs microélectroniques à architecture 3D 200 comprenant des transistors, mis en oeuvre à partir de l'empilement 100 selon le premier mode de réalisation, est décrit ci-dessous en lien avec la figure 2. Afin de simplifier la description de ce procédé, une partie seulement des couches de l'empilement 100 sont représentées sur la figure 2. En outre, différents éléments des transistors réalisés tels que la grille factice, les espaceurs latéraux, les régions de source et de drain, etc., ainsi que d'autres éléments du dispositif 200, ne sont pas représentés sur la figure 2 afin de faciliter la compréhension de l'invention.

Une première étape du procédé consiste à réaliser l'empilement 100 sur le substrat 102. Les différentes couches 104, 106, 108, 110 de l'empilement 100 peuvent être réalisées par épitaxie sur la face supérieure du substrat 102. L'empilement 100 obtenu à l'issue de ces étapes d'épitaxie correspond à celui représenté sur la figure 1.

Des tranchées et/ou des cavités (trous de contact par exemple) sont ensuite réalisées à travers au moins une partie de l'épaisseur de l'empilement 100 (toute l'épaisseur de l'empilement 100 sur l'exemple de la figure 2), de manière à ce que des portions restantes des différentes couches 104, 106 et 108 de l'empilement 100 forment des nanofils ou des nano-feuilles. Dans l'exemple de réalisation décrit ici, cette étape de gravure est également mise en oeuvre à travers la couche 110. Cette étape de gravure est mise en oeuvre en réalisant un masque de gravure (non représenté) au sommet de l'empilement 100, définissant le motif à graver à travers l'empilement 100. Cette gravure est par exemple une gravure sèche par plasma à base de C₄F₆/O₂ et/ou HBr/O₂. Dans le cas d'un substrat 102 de type SOI, cette gravure peut être arrêtée sur la couche diélectrique enterrée du substrat 102. Sur la figure 2, vue a, seule une des portions restantes de chacune des couches 104, 106, 108, 110 de l'empilement 100 est représentée.

Bien que cela ne soit pas visible sur la figure 2, la réalisation des dispositifs microélectroniques à architecture 3D 200 peut se poursuivre en formant par exemple une grille factice sur et contre des parois latérales des portions restantes de l'empilement 100. Des espaceurs latéraux, qui ne sont également pas visibles sur la figure 2, peuvent ensuite être réalisés à côté de la grille factice, également sur et contre les parois latérales des portions restantes de l'empilement 100.

Une gravure sélective d'une partie des portions restantes des premières couches 104, et également de la couche 110 dans l'exemple de réalisation décrit ici, est ensuite mise en oeuvre de manière à former des canaux des transistors qui seront réalisés à partir de l'empilement 100. Cette gravure du matériau des premières couches 104 et de la couche 110, c'est-à-dire du silicium non intentionnellement dopé, est sélective vis-à-vis des matériaux des autres couches 106 et 108 de l'empilement 100, c'est-à-dire sélective vis-à-vis du SiGe non intentionnellement dopé des deuxièmes couches 106 et du silicium dopé de type P des troisièmes couches 108. Dans l'exemple de réalisation décrit ici, cette gravure correspond à une gravure isotrope correspondant par exemple à une gravure humide pouvant être mise en oeuvre avec une solution à base d'EDP (ethylènediamine pyrocatéchol), de KOH, de NaOH et de LiOH.

Comme cela est visible sur la figure 2, vue b, cette gravure forme les futurs canaux 112 des transistors correspondant aux portions de matériau restantes des premières couches 104, et également de la couche 110 dans cet exemple. Avec la mise en oeuvre de cette gravure, des premiers espaces 114 sont formés également à côté des canaux 112, découvrant des flancs latéraux des canaux 112.

Un dépôt d'au moins un premier matériau diélectrique 116 dans les premiers espaces 114 est ensuite mis en oeuvre (voir figure 2, vue c). De manière avantageuse, ce premier matériau diélectrique 116 correspond à de l'oxyde, par exemple du SiO₂. Le dépôt mis en oeuvre est par exemple de type CVD ou ALD.

Une gravure sélective d'au moins une partie des portions restantes des deuxièmes couches 106, et de préférence de l'ensemble des portions restantes des deuxièmes couches 106, est ensuite mise en oeuvre. Cette gravure du matériau des deuxièmes couches 106, c'est-à-dire du SiGe non intentionnellement dopé, est sélective vis-à-vis des matériaux des autres couches 102, 108, 116 et 110 de l'empilement 100, c'est-à-dire sélective vis-à-vis du silicium non intentionnellement dopé des premières couches 104 et de la couche 110, du silicium dopé de type P des troisièmes couches 108, et également vis-à-vis du premier matériau diélectrique des portions 116. Dans l'exemple de réalisation décrit ici, cette gravure correspond par exemple à une gravure humide pouvant être mise en oeuvre avec une solution à base d'acide acétique HF H₂O₂ ou à base d'HNO₃ combinée avec des agents de gravure d'oxyde (détails de mise en oeuvre donnés par exemple dans le document « The Effect of Doping on the Digital Etching of Silicon-Selective Silicon-Germanium Using Nitric Acids » de Li et al., Nanomaterials, 2021, 11(5), 1209). Avec la mise en oeuvre de cette gravure, des seconds espaces sont formés entre les troisièmes couches 108.

Bien que cela ne soit pas visible sur la figure 2, la stabilité mécanique de l'empilement est assurée par la présence de matériaux situés en dehors des plans représentés sur la figure 2.

Un dépôt d'au moins un deuxième matériau diélectrique 118 dans les seconds espaces est ensuite mis en oeuvre (voir figure 2, vue d). A titre d'exemple, ce deuxième matériau diélectrique 118 correspond à du nitrure, par exemple du SiN. Le dépôt mis en oeuvre est par exemple de type CVD ou ALD. Les portions de ce deuxième matériau diélectrique 118 sont ici destinées à former des portions diélectriques d'isolation entre les grilles des différents niveaux des transistors GAA qui seront réalisées.

Une gravure sélective d'au moins une partie des portions restantes des troisièmes couches 108, et de préférence de l'ensemble des portions restantes des troisièmes couches 108, est ensuite mise en oeuvre. Cette gravure du matériau des troisièmes couches 108, c'est-à-dire du silicium dopé dans l'exemple décrit ici, est sélective vis-à-vis des matériaux présents, c'est-à-dire sélective vis-à-vis du silicium non intentionnellement dopé des premières couches 104 et de la couche 110, du SiGe non intentionnellement dopé des deuxièmes couches 106, et des premier et deuxième matériaux diélectriques des portions 116 et 118. Dans l'exemple de réalisation décrit ici, cette gravure correspond par exemple à une gravure humide pouvant être mise en oeuvre avec une solution à base d'HNA, c'est-à-dire de HF, de HNO₃ et d'acide propionique.

Un dépôt d'au moins un diélectrique de grille et d'au moins un matériau conducteur de grille dans des troisièmes espaces formés par la gravure sélective d'une des portions restantes des troisièmes couches 108, formant une grille 120 au-dessus et en-dessous de chacun des canaux 112 des transistors. Le diélectrique de grille et le matériau conducteur de grille correspondent par exemple à une superposition de HfO₂, de TiN et de W. La structure obtenue est représentée sur la figure 2, vue e.

En variante, il est possible que les portions 116 soient gravées avant que le diélectrique de grille et le matériau conducteur de grille ne soient déposés, et qu'un ou plusieurs matériaux différents de celui des portions 116 soient déposés dans les cavités obtenues par cette gravure.

D'autres étapes telles que la réalisation des espaceurs, des régions de source et de drain, des contacts électriques, des éléments mémoires lorsque l'empilement 100 sert à la réalisation de dispositifs mémoires 3D, etc., sont également mises en oeuvre pour achever la réalisation des dispositifs microélectroniques à architecture 3D 200.

En alternative, l'empilement 100 peut être avantageusement utilisé pour réaliser un dispositif mémoire 3D tel que celui décrit dans la demande de brevet FR 21 05264, ce qui permet, par rapport aux matériaux décrits dans la demande FR 21 05264, de réaliser un dispositif mémoire 3D comprenant un plus grand nombre de niveaux mémoires superposés, et donc une plus grande densité de mémoire / unité de surface.

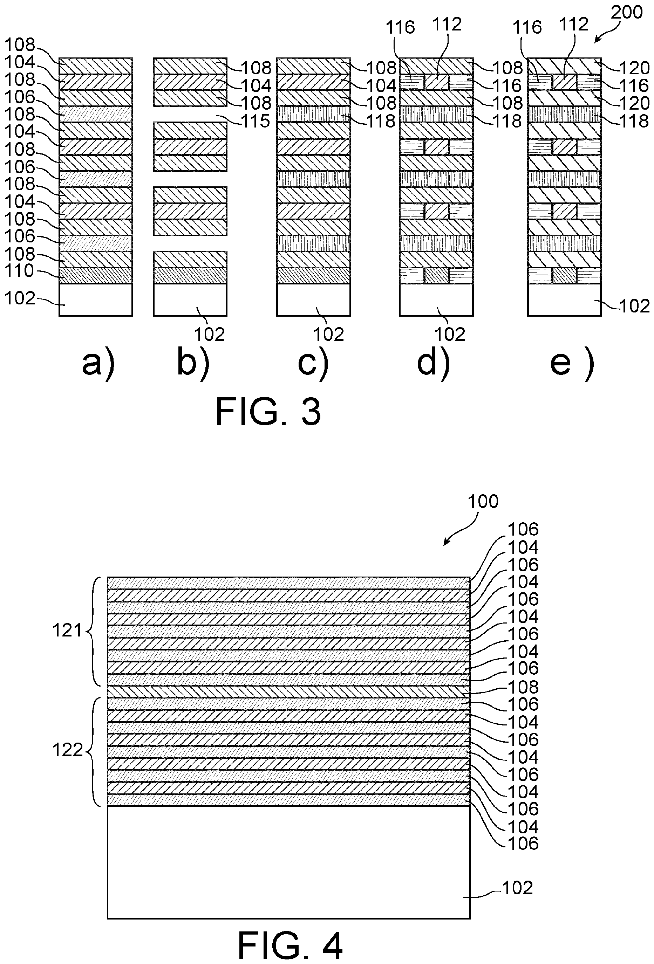

Un autre procédé de réalisation de dispositifs microélectroniques à architecture 3D 200 comprenant des transistors, mis en oeuvre à partir de l'empilement 100 selon le premier mode de réalisation, est décrit ci-dessous en lien avec la figure 3. Afin de simplifier la description de ce procédé, une partie seulement des couches de l'empilement 100 sont représentées sur la figure 3.

Dans ce procédé, les mêmes étapes que celles du procédé précédemment décrit en lien avec la figure 2 sont mises en oeuvre, mais dans un ordre différent. Ainsi, par rapport au procédé précédemment décrit en lien avec la figure 2, les étapes de gravure d'au moins une partie des portions restantes des deuxièmes couches 106 et de dépôt du deuxième matériau diélectrique 118 sont mises en oeuvre avant les étapes de gravure d'une partie des portions restantes des premières couches 104 et de dépôt du premier matériau diélectrique 116. Sur la figure 3, vue b, les espaces formés par la gravure d'au moins une partie des portions restantes des deuxièmes couches 106 sont désignés par la référence 115. Dans ce procédé, il est possible que le deuxième matériau diélectrique 118 corresponde à du SiCO ou du SiN. Comme dans le précédent procédé, après voir mis en oeuvre les dépôts des premier et deuxième matériaux diélectriques 116, 118, la gravure d'au moins une partie des portions restantes des troisièmes couches 108 et le dépôt des matériaux formant les grilles 120 des transistors sont mises en oeuvre.

En variante de l'empilement 100 précédemment décrit selon le premier mode de réalisation, il est possible que chacune des premières et troisièmes couches 104, 108 soit disposée entre deux deuxièmes couches 106 et soit en contact avec ces deux deuxièmes couches 106. Les deux procédés décrits ci-dessus peuvent être mis en oeuvre en faisant appel à un empilement 100 selon cette variante de réalisation, en adaptant dans ce cas les agents de gravure utilisés en fonction des matériaux à graver.

Dans les procédés décrits ci-dessus, les premières couches 104 sont utilisées pour former les canaux des transistors du dispositif réalisé. En variante, il est possible que les deuxièmes couches 106 soient partiellement gravées afin que les parties restantes des portions des deuxièmes couches 106 soient utilisées pour former les canaux des transistors des dispositifs réalisés.

L'empilement 100 selon le premier mode de réalisation ainsi que selon la variante ci-dessus du premier mode de réalisation est bien adapté pour la réalisation de dispositifs mémoires à architecture 3D 200 et par exemple de type 1T1R ou 1T1C.

Un empilement 100 de couches de matériaux monocristallins adapté à la réalisation de dispositifs microélectroniques à architecture 3D comprenant des transistors CFET, selon un deuxième mode de réalisation, est décrit ci-dessous en lien avec la figure 4.

Comme dans le premier mode de réalisation, l'empilement 100 selon le deuxième mode de réalisation est réalisé sur le substrat 102 et comporte des premières couches 104, des deuxièmes couches 106 et au moins une troisième couche 108 (une seule sur l'exemple de la figure 4). Les matériaux de ces couches 104, 106 et 108 sont similaires à ceux précédemment décrits en lien avec le premier mode de réalisation.

Dans ce deuxième mode de réalisation, les premières et deuxièmes couches 104 et 106 de l'empilement 100 sont réparties en formant plusieurs sous-empilements chacun séparé l'un de l'autre par une troisième couche 108. Sur l'exemple de la figure 4, l'empilement 100 comporte :
- un premier sous-empilement 121 formé d'une alternance de premières et deuxièmes couches 104, 106 tel que chaque première couche 104 du premier sous-empilement 121 soit disposé entre deux deuxièmes couches 106 du premier sous-empilement 121 ;
- un deuxième sous-empilement 122 formé d'une alternance de premières et deuxièmes couches 104, 106 tel que chaque première couche 104 du
deuxième sous-empilement 122 soit disposé entre deux deuxièmes couches 106 du deuxième sous-empilement 122.

L'empilement 100 représenté sur la figure 4 comporte également une troisième couche 108 disposée entre les premier et deuxième sous-empilements 121, 122.

Sur l'exemple de la figure 4, chacun des premier et deuxième sous-empilements 121, 122 comporte quatre premières couches 104 et cinq deuxièmes couches 106.

Les caractéristiques individuelles (épaisseur, dopage, etc.) de chacune des couches 104, 106, 108 de l'empilement selon ce deuxième mode de réalisation sont par exemple identiques à celles précédemment décrites pour l'empilement 100 selon le premier mode de réalisation.

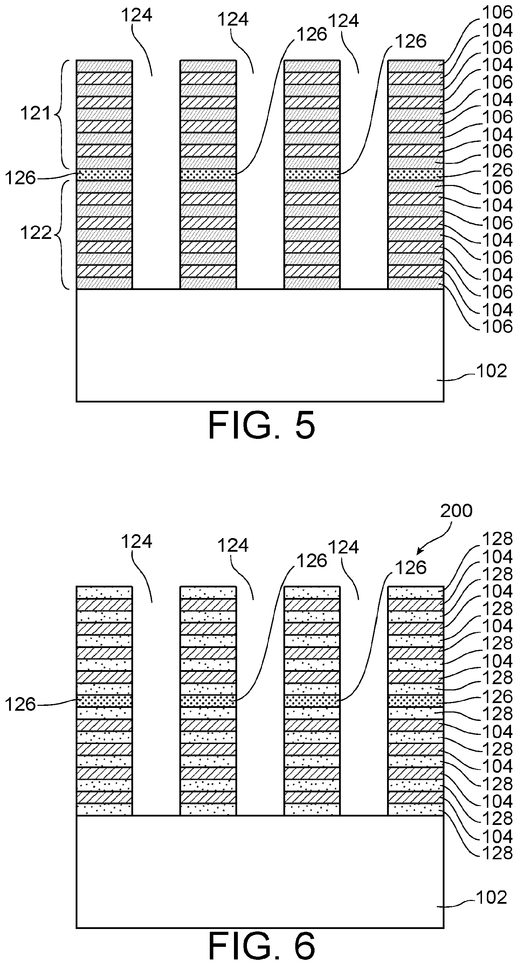

Un procédé de réalisation de dispositifs microélectroniques à architecture 3D 200 comprenant des transistors, mis en oeuvre à partir de l'empilement 100 selon le deuxième mode de réalisation, est décrit ci-dessous en lien avec les figures 5 et 6.

L'empilement 100 tel que décrit ci-dessus en lien avec la figure 4 est tout d'abord réalisé sur le substrat 102. Les différentes couches 104, 106 et 108 de l'empilement 100 peuvent être réalisées par épitaxie sur la face supérieure du substrat 102.

Comme dans les procédés précédemment décrits, des tranchées et/ou des cavités sont ensuite gravées à travers au moins une partie de l'épaisseur de l'empilement 100 (à travers toute l'épaisseur de l'empilement 100 dans l'exemple de réalisation décrit ici), de manière à ce que des portions restantes des différentes couches 104, 106 et 108 de l'empilement 100 forment des nanofils ou des nano-feuilles. Sur les figures 5 et 6, une partie de ces tranchées gravées sont désignées par la référence 124.

Une gravure sélective d'au moins une partie des portions restantes de la troisième couche 108, et de préférence de l'ensemble des portions restantes des troisièmes couches 108, est ensuite mise en oeuvre, puis au moins un premier matériau diélectrique 126, par exemple du SiO₂ ou du SiN, est déposé dans des premiers espaces formés entre les sous-empilements 121, 122. Ce premier matériau diélectrique 126 assure une isolation électrique entre les matériaux semi-conducteurs des sous-empilements 121, 122. La structure obtenue à ce stade du procédé est représentée sur la figure 5.

Une gravure sélective d'au moins une partie des portions restantes des deuxièmes couches 106 des sous-empilements 121, 122, et de préférence de l'ensemble des portions restantes des deuxièmes couches 106 des sous-empilements 121, 122, est mise en oeuvre postérieurement. Au moins un diélectrique de grille et au moins un matériau conducteur de grille sont ensuite déposés dans des deuxièmes espaces formés par la précédente gravure sélective des portions restantes des deuxièmes couches 106, formant une grille 128 au-dessus et en-dessous de chacune des portions restantes des premières couches 104 des sous-empilements 121, 122. La structure obtenue est représentée sur la figure 6.

D'autres étapes, non décrites ici, telles que la réalisation des espaceurs, des régions de source et de drain, des contacts électriques, etc., sont également mises en oeuvre pour achever la réalisation des dispositifs microélectroniques à architecture 3D 200. Ces dispositifs peuvent comporter des transistors de type CFET tels que l'un des transistors de type NMOS ou PMOS comporte un canal formé par les portions restantes des premières couches 104 du premier sous-empilement 121 et l'autre des transistors, respectivement de type PMOS ou NMOS, comporte un canal formé par les portions restantes des premières couches 104 du deuxième sous-empilement 122.

En variante de la configuration représentée sur la figure 4, il est possible que l'empilement 100 comporte :
- un premier sous-empilement 121 formé d'une alternance de premières et deuxièmes couches 104, 106 tel que chaque deuxième couche 106 du premier sous-empilement 121 soit disposée entre deux premières couches 104 du premier sous-empilement 121 ;
- un deuxième sous-empilement 122 formé d'une alternance de premières et deuxièmes couches 104, 106 tel que chaque deuxième couche 106 du deuxième sous-empilement 122 soit disposée entre deux premières couches 104 du deuxième sous-empilement 122.

Dans ce cas, lors de la réalisation de dispositifs microélectroniques à architecture 3D à partir d'un tel empilement, ce sont les portions restantes des premières couches 104 des sous-empilements 121, 122 qui sont gravées sélectivement vis-à-vis des portions restantes des deuxièmes couches 106. Les grilles 128 sont réalisées ensuite au-dessus et en-dessous de chacune des portions restantes des deuxièmes couches 106 des sous-empilements 121, 122 qui sont destinées à former les canaux des transistors.

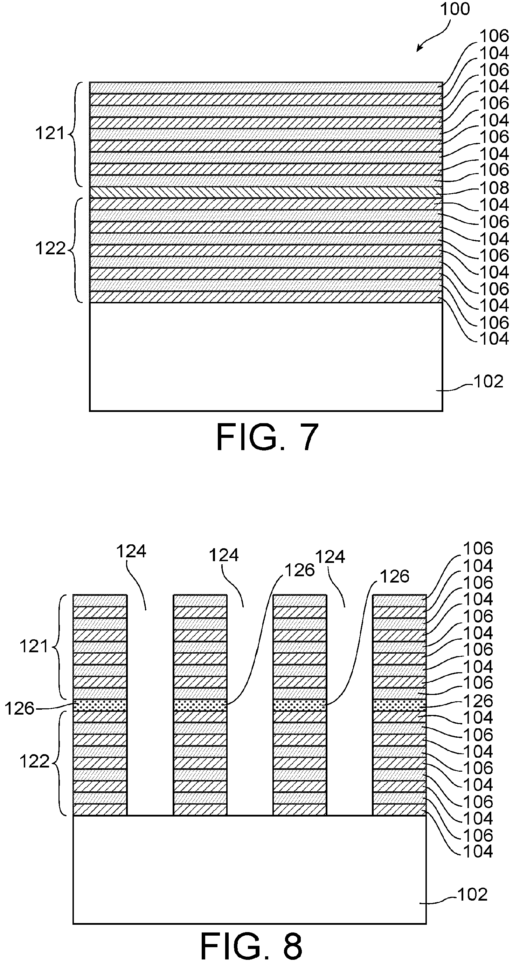

Un empilement 100 de couches de matériaux monocristallins adapté à la réalisation de dispositifs microélectroniques à architecture 3D comprenant des transistors de type GAA, selon une variante du deuxième mode de réalisation, est décrit ci-dessous en lien avec la figure 7.

Comme dans les précédents modes de réalisation, l'empilement 100 selon cette variante du deuxième mode de réalisation est réalisé sur le substrat 102 et comporte des premières couches 104, des deuxièmes couches 106 et au moins une troisième couche 108 (une seule sur l'exemple de la figure 7). Les matériaux de ces couches 104, 106 et 108 sont similaires à ceux précédemment décrits en lien avec les premier et deuxième modes de réalisation.

Comme dans le deuxième mode de réalisation, les premières et deuxièmes couches 104 et 106 de l'empilement 100 sont réparties en formant plusieurs sous-empilements chacun séparé l'un de l'autre par une troisième couche 108. Sur l'exemple de la figure 7, l'empilement 100 comporte :
- un premier sous-empilement 121 formé d'une alternance de premières et deuxièmes couches 104, 106 tel que chaque première couche 104 du premier sous-empilement 121 soit disposée entre deux deuxièmes couches 106 du premier sous-empilement 121 ;
- un deuxième sous-empilement 122 formé d'une alternance de premières et deuxièmes couches 104, 106 tel que chaque deuxième couche 106 du deuxième sous-empilement 122 soit disposée entre deux premières couches 104 du deuxième sous-empilement 122.

L'empilement 100 représenté sur la figure 7 comporte également une troisième couche 108 disposée entre les premier et deuxième sous-empilements 121, 122.

Sur l'exemple de la figure 7, le premier sous-empilement 121 comporte quatre premières couches 104 et cinq deuxièmes couches 106, le deuxième sous-empilement 122 comporte cinq premières couches 104 et quatre deuxièmes couches 106.

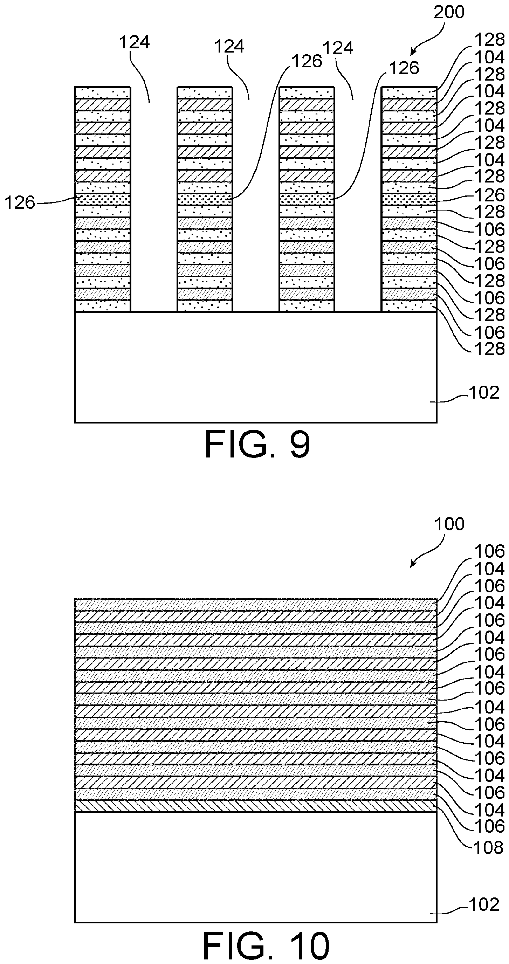

Un procédé de réalisation de dispositifs microélectroniques à architecture 3D comprenant des transistors, mis en oeuvre à partir de l'empilement 100 selon cette variante du deuxième mode de réalisation, est décrit ci-dessous en lien avec les figures 8 et 9.

L'empilement 100 tel que décrit ci-dessus en lien avec la figure 7 est tout d'abord réalisé sur le substrat 102. Les différentes couches 104, 106 et 108 de l'empilement 100 peuvent être réalisées par épitaxie sur la face supérieure du substrat 102.

Comme dans les procédés précédemment décrits, des tranchées et/ou des cavités sont ensuite réalisées à travers au moins une partie de l'épaisseur de l'empilement 100 (à travers toute l'épaisseur de l'empilement 100 dans l'exemple décrit ici), de manière à ce que des portions restantes des différentes couches 104, 106 et 108 de l'empilement 100 forment des nanofils ou des nano-feuilles. Sur les figures 8 et 9, une partie de ces tranchées gravées sont désignées par la référence 124.

Une gravure sélective d'au moins une partie des portions restantes de la troisième couche 108, et de préférence de l'ensemble des portions restantes des troisièmes couches 108, est ensuite mise en oeuvre, puis au moins un premier matériau diélectrique 126, par exemple du SiO₂ ou du SiN, est déposé dans des premiers espaces formés entre les sous-empilements 121, 122. Ce premier matériau diélectrique 126 est destiné à assurer une isolation électrique entre les sous-empilements 121, 122. La structure obtenue à ce stade du procédé est représentée sur la figure 8.

Une gravure sélective d'au moins une partie des portions restantes des deuxièmes couches 106 du premier sous-empilement 121, et de préférence l'ensemble des portions restantes des deuxièmes couches 106 du premier sous-empilement 121, est mise en oeuvre postérieurement.

Une gravure sélective d'au moins une partie des portions restantes des premières couches 104 du deuxième sous-empilement 122, et de préférence l'ensemble des portions restantes des premières couches 104 du deuxième sous-empilement 122, est mise en oeuvre postérieurement. Lors de ces étapes, le premier sous-empilement 121 est protégé afin de ne pas endommager les matériaux du premier sous-empilement 121 lors de cette gravure sélective.

Au moins un diélectrique de grille et au moins un matériau conducteur de grille sont déposés dans des deuxièmes et troisièmes espaces formés par la gravure sélective des portions restantes des deuxièmes couches 106 du premier sous-empilement 121 et par la gravure sélective des portions restantes des premières couches 104 du deuxième sous-empilement 122, formant une grille 128 au-dessus et en-dessous de chacune des portions restantes des premières couches 104 du premier sous-empilement 121 et des portions restantes des deuxièmes couches 106 du deuxième sous-empilement 122.

D'autres étapes, non décrites ici, telles que la réalisation des espaceurs, des régions de source et de drain, des contacts électriques, etc., sont également mises en oeuvre pour achever la réalisation des dispositifs microélectroniques à architecture 3D 200. Ces dispositifs peuvent comporter des transistors de type CFET tels que des transistors NMOS comportent un canal formé par les portions restantes des premières couches 104 du premier sous-empilement 121 et des transistors PMOS comportent un canal formé par les portions restantes des deuxièmes couches 106 du deuxième sous-empilement 122.

En variante, il est également possible que les transistors PMOS aient leurs canaux formés par les portions restantes des premières couches 104 du premier sous-empilement 121 et que les transistors NMOS aient leurs canaux formés par les portions restantes des premières couches 104 du premier sous-empilement 121.

En variante du procédé décrit ci-dessus en lien avec les figures 7 à 9, il est possible de réaliser tout d'abord la gravure des portions restantes des premières couches 104 du deuxième sous-empilement 122, puis la gravure des portions restantes des deuxièmes couches 106 du premier sous-empilement 121, et enfin la réalisation des grilles 128 dans les deux sous-empilements 121, 122.

En variante de l'empilement 100 précédemment décrit en lien avec la figure 7, il est possible de réaliser cet empilement 100 tel que :
- le premier sous-empilement 121 soit formé d'une alternance de premières et deuxièmes couches 104, 106 tel que chaque deuxième couche 106 du premier sous-empilement 121 soit disposée entre deux premières couches 104 du premier sous-empilement 121 ;
- le deuxième sous-empilement 122 soit formé d'une alternance de premières et deuxièmes couches 104, 106 tel que chaque première couche 104 du deuxième sous-empilement 122 soit disposée entre deux deuxièmes couches 106 du deuxième sous-empilement 122.

Dans ce cas, dans les différents procédés décrits ci-dessus pouvant s'appliquer à un tel empilement, la gravure sélective mise en oeuvre dans le premier sous-empilement 121 correspond à une gravure sélective des portions restantes des premières couches 104 du premier sous-empilement 121 vis-à-vis des portions restantes des deuxièmes couches 106 du premier sous-empilement 121, et la gravure sélective mise en oeuvre dans le deuxième sous-empilement 122 correspond à une gravure sélective des portions restantes des deuxièmes couches 106 du deuxième sous-empilement 122 vis-à-vis des portions restantes des premières couches 104 du deuxième sous-empilement 122.

Lorsque l'empilement 100 comporte plusieurs sous-empilements comme décrit précédemment, il est possible que cet empilement 100 comporte en outre plusieurs autres troisièmes couches 108 de silicium dopé de type P ou du SiGe dopé de type P entre lesquelles les sous-empilements 121, 122 sont disposés.

Lorsque les couches de matériaux de l'empilement 100 sont réparties dans plusieurs sous-empilements comme c'est le cas dans les exemples précédemment décrits, le nombre total de couches de matériaux de chacun des sous-empilements 121, 122 destinées à former des canaux de transistors est avantageusement compris entre 3 et 10. De plus, le nombre de couches de matériaux dans chacun des sous-empilements peut être le même ou non. Par exemple, en considérant les exemples de réalisation précédemment décrits en lien avec les figures 4 et 7, le nombre de couches de matériaux du premier sous-empilement 121 pourrait être différent de celui du deuxième sous-empilement 122. Enfin, l'empilement 100 peut comporter plus de deux sous-empilements de couches de matériaux monocristallins.

Un empilement 100 de couches de matériaux monocristallins adapté à la réalisation de dispositifs microélectroniques à architecture 3D comprenant des transistors de type GAA, selon un troisième mode de réalisation, est décrit ci-dessous en lien avec la figure 10.

Comme dans les précédents modes de réalisation, l'empilement 100 selon le troisième mode de réalisation est réalisé sur le substrat 102 et comporte des premières couches 104, des deuxièmes couches 106 et au moins une troisième couche 108 (une seule sur l'exemple de la figure 10). Les matériaux de ces couches 104, 106 et 108 sont similaires à ceux précédemment décrits en lien avec les précédents modes de réalisation.

Dans ce troisième mode de réalisation, les premières et deuxièmes couches 104 et 106 de l'empilement 100 sont disposées les unes au-dessus des autres de manière alternée. Sur l'exemple représenté sur la figure 10, chaque première couche 104 est disposée entre deux deuxièmes couches 106 et est en contact avec ces deux deuxièmes couches 106.

L'empilement 100 représenté sur la figure 10 comporte également une troisième couche 108 disposée sous les premières et deuxièmes couches 104, 106, entre le substrat 102 et l'ensemble des premières et deuxièmes couches 104, 106.

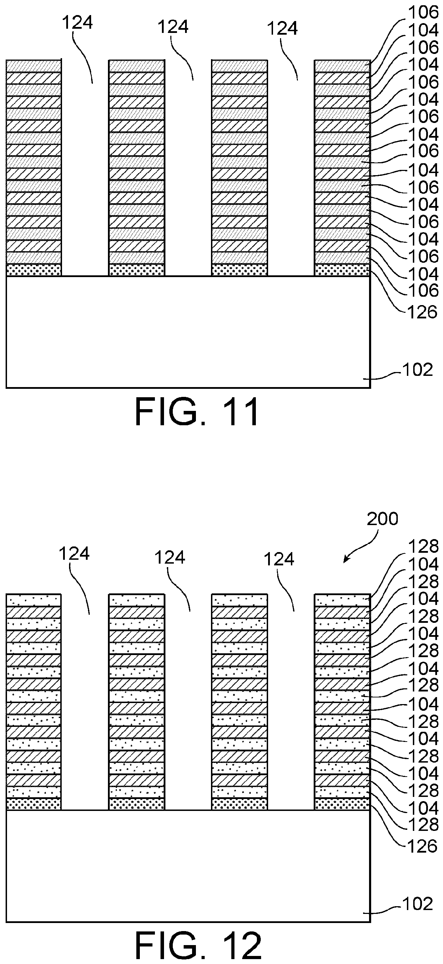

Un procédé de réalisation de dispositifs microélectroniques à architecture 3D comprenant des transistors, mis en oeuvre à partir de l'empilement 100 selon le troisième mode de réalisation, est décrit ci-dessous en lien avec les figures 11 et 12.

L'empilement 100 tel que décrit ci-dessus en lien avec la figure 10 est tout d'abord réalisé sur le substrat 102. Les différentes couches 104, 106 et 108 de l'empilement 100 peuvent être réalisées par épitaxie sur la face supérieure du substrat 102.

Comme dans les procédés précédemment décrits, des tranchées et/ou des cavités sont ensuite réalisées à travers toute l'épaisseur de l'empilement 100, de manière à ce que des portions restantes des différentes couches 104, 106 et 108 de l'empilement 100 forment des nanofils ou des nano-feuilles. Sur les figures 11 et 12, une partie de ces tranchées gravées sont désignées par la référence 124.

Une gravure sélective d'au moins une partie des portions restantes de la troisième couche 108, et de préférence de l'ensemble des portions restantes de la troisième couche 108, est ensuite mise en oeuvre. Au moins un premier matériau diélectrique 126, par exemple du SiO₂ ou du SiN, est déposé de manière conforme, par exemple par un dépôt de type ALD ou CVD, puis gravé de façon sélective et isotrope afin de ne conserver des portions de ce premier matériau diélectrique que sous les portions restantes des couches 104, 106. Ce premier matériau diélectrique 126 assure une isolation électrique entre le substrat 102 et le canal le plus proche du substrat 102. La structure obtenue à ce stade du procédé est représentée sur la figure 11.

Une gravure sélective d'une partie des portions restantes des deuxièmes couches 106 de l'empilement 100 est ensuite mise en oeuvre. Au moins un diélectrique de grille et au moins un matériau conducteur de grille sont ensuite déposés dans des deuxièmes espaces formés par la précédente gravure sélective des portions restantes des deuxièmes couches 106, formant une grille 128 au-dessus et en dessous, ou autour, de chacune des portions restantes des premières couches 104 de l'empilement 100.

La structure obtenue à l'issue du procédé est représentée sur la figure 12. D'autres étapes, non décrites ici, telles que la réalisation des régions de source et de drain, des contacts électriques, etc., sont mises en oeuvre pour achever la réalisation des dispositifs microélectroniques à architecture 3D 200 qui correspondent à des transistors MOS GAA.

En variante du quatrième mode de réalisation décrit ci-dessus, il est possible que chaque deuxième couche 106 soit disposée entre deux premières couches 104 et soit en contact avec ces deux premières couches 104. Dans ce cas, après avoir déposé le premier matériau diélectrique 126, une gravure sélective d'une partie des portions restantes des premières couches 104 de l'empilement 100 est mise en oeuvre. Au moins un diélectrique de grille et au moins un matériau conducteur de grille sont ensuite déposés dans les deuxièmes espaces formés par la précédente gravure sélective des portions restantes des premières couches 104, formant une grille 128 au-dessus et en dessous, ou autour, de chacune des portions restantes des deuxièmes couches 106 de l'empilement 100.

## Revendications

1. Empilement (100) de couches adapté à la réalisation de dispositifs microélectroniques à architecture 3D comprenant des transistors, incluant plusieurs premières couches (104) de silicium non intentionnellement dopé, plusieurs deuxièmes couches (106) de SiGe non intentionnellement dopé, et au moins une troisième couche (108) de silicium dopé de type P ou du SiGe dopé de type P, et tel que les premières, deuxièmes et troisième couches (104, 106, 108) soient empilées les unes au-dessus des autres,
ladite au moins une troisième couche (108) ayant une face dite « inférieure » disposée sur et en contact d'une couche semi-conductrice donnée parmi lesdites premières (104) ou deuxièmes couches (106) ou étant disposée sur et en contact d'une couche semi-conductrice d'un substrat, ladite au moins une troisième couche (108) étant dotée d'une face dite « supérieure » opposée à ladite face inférieure, ladite face supérieure étant disposée sous et en contact avec une autre couche semi-conductrice parmi lesdites premières ou deuxièmes couches.

2. Empilement (100) selon la revendication 1, l'empilement étant entièrement constitué de trois matériaux semiconducteur différents.

3. Empilement (100) selon la revendication 2, l'empilement étant entièrement constitué de premières couches (104) de silicium non intentionnellement dopé, de deuxièmes couches (106) de SiGe non intentionnellement dopé, et d'au moins une troisième couche (108) de silicium dopé de type P ou du SiGe dopé de type P.

4. Empilement (100) de couches selon l'une des revendications 1 à 3,
dans lequel le silicium ou le SiGe de la troisième couche (108) a une concentration en dopants de type P supérieure ou égale à 5.10¹⁹ at/cm³,
et/ou
dans lequel le SiGe intrinsèque a une concentration en germanium supérieure ou égale à 10 % et inférieure à 50 %,
et/ou
dans lequel le nombre de premières ou deuxièmes couches (104, 106) de l'empilement (100) est compris entre 4 et 300.

5. Empilement (100) de couches selon l'une des revendications précédentes, dans lequel chacune des premières et deuxièmes couches (104, 106) est disposée entre deux troisièmes couches (108) et est en contact avec ces deux troisièmes couches (108).

6. Empilement (100) de couches selon l'une des revendications 1 à 4, comportant en outre plusieurs autres troisièmes couches de silicium dopé de type P ou du SiGe dopé de type P, et dans lequel chacune des premières et troisièmes couches (104, 108) est disposée entre deux des deuxièmes couches (106) et est en contact avec ces deux deuxièmes couches (106).

7. Empilement (100) de couches selon l'une des revendications 1 à 4, comprenant au moins :
- un premier sous-empilement (121) formé d'une alternance de premières et deuxièmes couches (104, 106) et tel que chaque première couche (104) du premier sous-empilement (121) soit disposé entre deux deuxièmes couches (106) du premier sous-empilement (121) ou que chaque deuxième couche (106) du premier sous-empilement (121) soit disposée entre deux premières couches (104) du premier sous-empilement (121) ;
- un deuxième sous-empilement (122) formé d'une alternance de premières et deuxièmes couches (104, 106) et tel que chaque première couche (104) du deuxième sous-empilement (122) soit disposée entre deux deuxièmes couches (106) du deuxième sous-empilement (122) ou que chaque deuxième couche (106) du deuxième sous-empilement (122) soit disposée entre deux premières couches (104) du deuxième sous-empilement (122) ;
et dans lequel la troisième couche (108) est disposée entre les premier et deuxième sous-empilements (121, 122).

8. Empilement (100) de couches selon la revendication 7, comportant en outre plusieurs autres troisièmes couches de silicium dopé de type p ou du SiGe dopé de type p entre lesquelles les premier et deuxième sous-empilements (121, 122) sont disposés.

9. Empilement (100) de couches selon l'une des revendications 1 à 5, dans lequel les premières et deuxièmes couches (104, 106) sont disposées les unes au-dessus des autres de manière alternée, et la troisième couche (108) est disposée sous un ensemble formé par les premières et deuxièmes couches (104, 106).

10. Procédé de réalisation de dispositifs microélectroniques à architecture 3D (200) comprenant des transistors, comportant la mise en oeuvre des étapes suivantes :
a) réalisation d'un empilement (100) selon la revendication 5 sur un substrat (102) ;
b) gravure de tranchées (124) et/ou de cavités à travers au moins une partie de l'épaisseur de l'empilement (100), telle que des portions restantes des premières, deuxièmes et troisièmes couches (104, 106, 108) forment des nanofils ou des nano-feuilles ;
c) gravure sélective d'une partie des portions restantes des premières couches (104) telle que des parties restantes (112) des premières couches (104) soient configurées pour former des canaux des transistors ;
d) dépôt d'au moins un premier matériau diélectrique (116) dans des premiers espaces (114) formés par la gravure sélective d'une partie des portions restantes (112) des premières couches (104), à côté des canaux des transistors ;
e) gravure sélective d'au moins une partie des portions restantes des deuxièmes couches (106) ;
f) dépôt d'au moins un deuxième matériau diélectrique (118) dans des seconds espaces (115) formés par la gravure sélective d'au moins une partie des portions restantes des deuxièmes couches (106), entre les portions restantes des troisièmes couches(108) ;
g) gravure sélective des portions restantes des troisièmes couches (108) ;
h) dépôt d'au moins un diélectrique de grille et d'au moins un matériau conducteur de grille dans des troisièmes espaces formés par la gravure sélective des portions restantes des troisièmes couches (108), formant une grille (120) au moins au-dessus et en dessous de chacun des canaux des transistors.

11. Procédé de réalisation de dispositifs microélectroniques à architecture 3D (200) comprenant des transistors, comportant la mise en oeuvre des étapes suivantes :
a) réalisation d'un empilement (100) selon la revendication 5 sur un substrat (102) ;
b) gravure de tranchées (124) et/ou de cavités à travers au moins une partie de l'épaisseur de l'empilement (100), telle que des portions restantes des premières, deuxièmes et troisièmes couches (104, 106, 108) forment des nanofils ou des nano-feuilles ;
c) gravure sélective d'une partie des portions restantes des deuxièmes couches (106) telle que des parties restantes des deuxièmes couches (106) soient configurées pour former des canaux des transistors ;
d) dépôt d'au moins un premier matériau diélectrique (116) dans des premiers espaces (114) formés par la gravure sélective d'une partie des portions restantes des premières couches (106), à côté des canaux des transistors ;
e) gravure sélective d'au moins une partie des portions restantes des premières couches (104) ;
f) dépôt d'au moins un deuxième matériau diélectrique (118) dans des seconds espaces (115) formés par la gravure sélective d'au moins une partie des portions restantes des premières couches (104), entre les portions restantes des troisièmes couches (108) ;
g) gravure sélective des portions restantes des troisièmes couches (108) ;
h) dépôt d'au moins un diélectrique de grille et d'au moins un matériau conducteur de grille dans des troisièmes espaces formés par la gravure sélective des portions restantes des troisièmes couches (108), formant une grille (120) au moins au-dessus et en dessous de chacun des canaux des transistors.

12. Procédé de réalisation de dispositifs microélectroniques à architecture 3D (200) comprenant des transistors, comportant la mise en oeuvre des étapes suivantes :
a) réalisation d'un empilement (100) selon la revendication 6 sur un substrat (102) ;
b) gravure de tranchées (124) et/ou de cavités à travers au moins une partie de l'épaisseur de l'empilement (100), telle que des portions restantes des premières, deuxièmes et troisièmes couches (104, 106, 108) forment des nanofils ou des nano-feuilles ;
c) gravure sélective d'une partie des portions restantes des premières couches (104) telle que des parties restantes (112) des premières couches (104) soient configurées pour former des canaux des transistors ;
d) dépôt d'au moins un premier matériau diélectrique (116) dans des premiers espaces (114) formés par la gravure sélective d'une partie des portions restantes (112) des premières couches (104), à côté des canaux des transistors ;
e) gravure sélective d'au moins une partie des portions restantes des troisièmes couches (108) ;
f) dépôt d'au moins un deuxième matériau diélectrique (118) dans des seconds espaces (115) formés par la gravure sélective d'au moins une partie des portions restantes des troisièmes couches (108), entre les portions restantes des deuxièmes couches(106) ;
g) gravure sélective des portions restantes des deuxièmes couches (106) ;
h) dépôt d'au moins un diélectrique de grille et d'au moins un matériau conducteur de grille dans des troisièmes espaces formés par la gravure sélective des portions restantes des deuxièmes couches (106), formant une grille (120) au moins au-dessus et en dessous de chacun des canaux des transistors.

13. Procédé selon l'une des revendications 10 à 12, dans lequel les étapes e) et f) sont mises en oeuvre entre les étapes b) et c).

14. Procédé de réalisation de dispositifs microélectroniques à architecture 3D (200) comprenant des transistors, comportant la mise en oeuvre des étapes suivantes :
a) réalisation d'un empilement (100) selon l'une des revendications 7 ou 8 sur un substrat (102) ;
b) gravure de tranchées (124) et/ou de cavités à travers au moins une partie de l'épaisseur de l'empilement (100), telle que des portions restantes des premières et deuxièmes couches (104, 106) des premier et deuxième sous-empilements (121, 122) et des portions restantes de la troisième couche (108) ou des troisièmes couches forment des nanofils ou des nano-feuilles ;
c) gravure sélective d'au moins une partie des portions restantes de la troisième couche (108) ou des troisièmes couches ;
d) dépôt d'au moins un premier matériau diélectrique (126) dans des premiers espaces formés par la gravure sélective d'au moins une partie des portions restantes de la troisième couche (108) ou des troisièmes couches ;
e) gravure sélective d'au moins une partie des portions restantes des deuxièmes couches (106) du premier sous-empilement (121) lorsque, dans le premier sous-empilement (121), chaque première couche (104) est disposée entre deux deuxièmes couches (106), ou gravure sélective d'au moins une partie des portions restantes des premières couches (104) du premier sous-empilement (121) lorsque, dans le premier sous-empilement (121), chaque deuxième couche (106) est disposée entre deux premières couches(104);
f) dépôt d'au moins un diélectrique de grille et d'au moins un matériau conducteur de grille dans des deuxièmes espaces formés par la gravure sélective de l'étape e), formant une grille (128) au moins au-dessus et en dessous de chacune des portions restantes des premières ou deuxièmes couches (104, 106) du premier sous-empilement (121).

15. Procédé selon la revendication 14, dans lequel :
- lorsque chaque première couche (104) est disposée entre deux deuxièmes couches (106) dans les premier et deuxième sous-empilements (121, 122), l'étape e) inclut également une gravure sélective d'au moins une partie des portions restantes des deuxièmes couches (106) du deuxième sous-empilement (122), et l'étape f) inclut également un dépôt du diélectrique de grille et du matériau conducteur de grille dans des troisièmes espaces formés par la gravure sélective d'au moins une partie des portions restantes des deuxièmes couches (106) du deuxième sous-empilement (122), formant une grille (128) au moins au-dessus et en dessous de chacune des portions restantes des premières couches (104) du deuxième sous-empilement (122), ou
- lorsque chaque deuxième couche (106) est disposée entre deux premières couches (104) dans les premier et deuxième sous-empilements (121, 122), l'étape e) inclut également une gravure sélective d'au moins une partie des portions restantes des premières couches (104) du deuxième sous-empilement (122), et l'étape f) inclut également un dépôt du diélectrique de grille et du matériau conducteur de grille dans des troisièmes espaces formés par la gravure sélective d'au moins une partie des portions restantes des premières couches (104) du deuxième sous-empilement (122), formant une grille (128) au moins au-dessus et en dessous de chacune des portions restantes des deuxièmes couches (106) du deuxième sous-empilement (122), ou
- lorsque chaque première couche (104) est disposée entre deux deuxièmes couches (106) dans le premier sous-empilement (121) et que chaque deuxième couche (106) est disposée entre deux premières couches (104) dans le deuxième sous-empilement (122), le procédé comporte en outre, après l'étape f), une étape g) de gravure sélective d'au moins une partie des portions restantes des premières couches (104) du deuxième sous-empilement (122), puis une étape h) de dépôt d'au moins un diélectrique de grille et d'au moins un matériau conducteur de grille dans des troisièmes espaces formés par la gravure sélective d'au moins une partie des portions restantes des premières couches (104) du deuxième sous-empilement (122), formant une grille (128) au moins au-dessus et en dessous de chacune des portions restantes des deuxièmes couches (106) du premier sous-empilement (121), ou
- lorsque chaque deuxième couche (106) est disposée entre deux premières couches (104) dans le premier sous-empilement (121) et que chaque première couche (104) est disposée entre deux deuxièmes couches (106) dans le deuxième sous-empilement (122), le procédé comporte en outre, après l'étape f), une étape g) de gravure sélective d'au moins une partie des portions restantes des deuxièmes couches (106) du deuxième sous-empilement (122), puis une étape h) de dépôt d'au moins un diélectrique de grille et d'au moins un matériau conducteur de grille dans des troisièmes espaces formés par la gravure sélective d'au moins une partie des portions restantes des deuxièmes couches (106) du deuxième sous-empilement (122), formant une grille (128) au moins au-dessus et en dessous de chacune des portions restantes des premières couches (104) du premier sous-empilement (121).

16. Procédé de réalisation de dispositifs microélectroniques à architecture 3D (200) comprenant des transistors, comportant la mise en oeuvre des étapes suivantes :
a) réalisation d'un empilement (100) selon la revendication 9 sur un substrat (102) ;
b) gravure de tranchées (124) et/ou de cavités à travers au moins une partie de l'épaisseur de l'empilement (100), telle que des portions restantes des premières et deuxièmes couches (104, 106) des premier et deuxième sous-empilements (121, 122) et des portions restantes de la troisième couche (108) forment des nanofils ou des nano-feuilles ;
c) gravure sélective d'au moins une partie des portions restantes de la troisième couche (108) ;
d) dépôt d'au moins un premier matériau diélectrique dans des premiers espaces formés sous les portions restantes des premières et deuxièmes couches (104, 106), assurant une isolation électrique entre les portions restantes des premières et deuxièmes couches (104, 106) et le substrat (102) ;
e) gravure sélective d'au moins une partie des portions restantes des premières couches (104) ou des deuxièmes couches (106) ;
f) dépôt d'au moins un diélectrique de grille et d'au moins un matériau conducteur de grille dans des deuxièmes espaces formés par la gravure d'au moins une partie des portions restantes des premières couches (104) ou des deuxièmes couches (106), formant une grille (128) au moins au-dessus et en dessous de chacune des portions restantes des premières couches (104) ou des deuxièmes couches (106).
